# EUROPEAN PATENT APPLICATION

(11) **EP 2 672 525 A1**
(43) Date of publication of application: **11.12.2013**
(21) Application number: 12741869.7
(22) Date of filing: 30.01.2012
(51) Int. Cl.: H01L 31/042, B32B 9/00

(54) **SURFACE PROTECTIVE MATERIAL FOR SOLAR CELL, AND SOLAR CELL MODULE PRODUCED USING SAME**

(30) Priority: 31.01.2011 JP 2011018655; 31.01.2011 JP 2011018663; 23.05.2011 JP 2011115088
(71) Applicant: Mitsubishi Plastics, Inc., Tokyo 100-8252 (JP)
(72) Inventor: AKAIKE, Osamu, Ushiku-shi Ibaraki 300-1201 (JP); AYA, Tetsuya, Ushiku-shi Ibaraki 300-1201 (JP); TAKAGI, Shigeharu, Ushiku-shi Ibaraki 300-1201 (JP); OCHIAI, Tatsuya, Nagoya-shi Aichi 453-0862 (JP); HIRA, Natsuki, Nagoya-shi Aichi 453-0862 (JP)
(74) Representative: Ter Meer Steinmeister & Partner
(86) International application number: PCT/JP2012/052019
(87) International publication number: WO 2012/105512

(57) **Abstract**

An excellent surface protective material having moisture proofness that is not deteriorated for a prolonged period of time is provided for a highly moisture proof surface protective material for a solar cell, containing a moisture proof film that comprises a substrate having on one surface thereof an inorganic thin film layer and has a water vapor permeability of less than 0.1 g/m²·day. The surface protective material for a solar cell contains: a moisture proof film that comprises a substrate having on one surface thereof an inorganic thin film layer and has a water vapor permeability of less than 0.1 g/m²·day, a weatherproof film on a side of the inorganic thin film layer of the moisture proof film; and a back surface film that has a melting point of 80°C or more and 180°C or less on the opposite side of the moisture proof film from the inorganic thin film layer.

## Description

### Technical Field

The present invention relates to a highly moisture proof surface protective material for a solar cell having a moisture proof film containing an inorganic thin film layer, in which the surface protective material for a solar cell has excellent moisture proofness without deterioration in long-term use, and relates to a highly durable solar cell module using the surface protective material for a solar cell.

### Background Art

In recent years, a solar cell, which converts solar light directly to electric energy, is receiving attention and thus being developed from the viewpoint of effective utilization of the resources, prevention of environmental contamination, and the like. A solar cell has a structure that contains an upper protective material on the light receiving side and an upper protective material, between which a solar cell device is sealed with an encapsulant material, such as films of an ethylene-vinyl acetate copolymer, polyethylene and polypropylene, and is generally produced by laminating and melting under heat the upper protective material, the encapsulant material, the electric power generation device (i.e., the solar cell device), the encapsulant material and the lower protective material, thereby adhering and integrating them.
Significantly important factors of the upper protective material and the lower protective material (which hereinafter each are referred to as a surface protective material) of a solar cell include durability to an ultraviolet ray and excellent moisture proofness, which prevents deterioration of the solar cell device and formation of rust on conductive wire and electrodes inside, due to penetration of moisture or water.
Examples of the surface protective material for a solar cell having been proposed for satisfying the demands include a laminated material having a structure containing, from the exposure side, a weatherproof film, a moisture proof film having a vapor-deposited inorganic thin film on the exposure side, and a film having adhesiveness and partial discharge resistance, such as an encapsulant material.

For example, Patent document 1 discloses in the examples thereof a surface protective material for a solar cell that is obtained by providing polyurethane adhesive layers on both surfaces of a moisture proof film containing a biaxially stretched polyester film as a substrate, and laminating weatherproof polyester films on both surfaces thereof.
Patent document 2 discloses in the examples thereof a surface protective material for a solar cell that is obtained by adhering a polyvinyl fluoride (PVF) film on the similar moisture proof film containing a biaxially stretched polyester film as a substrate, with a two-component curing polyurethane adhesive.
Patent document 3 discloses a back surface protective sheet for a solar cell module that contains a weatherproof resin layer having weather resistance on the back surface thereof, and contains a first vapor deposition resin layer having a vapor-deposited film of a metal oxide on one surface thereof, an intermediate resin layer, and a second vapor deposition resin layer having a vapor-deposited film of a metal oxide on one surface thereof, which are laminated with the weatherproof resin layer through a dry lamination process, in which the vapor-deposited films of the first vapor deposition resin layer and the second vapor deposition resin layer are disposed on the side of the intermediate resin layer.
Patent document 4 discloses a method for producing a back surface protective sheet for a solar cell module containing a weatherproof resin layer having weather resistance on the back surface thereof, and the method for producing a back surface protective sheet for a solar cell module contains laminating the weatherproof resin layer sequentially with at least three layers of vapor deposition resin layers each having a vapor-deposited film of a metal oxide on one surface thereof, through a dry lamination process, in which the vapor deposition resin layers each have a water vapor permeability at 40°C and 90%RH of from 0.03 to 0.5 g/m²·day.

### Citation List

### Patent documents

Patent document 1: JP-A-2009-188072
Patent document 2: JP-A-2009-49252
Patent document 3: JP-A-2010-272761
Patent document 4: JP-A-2010-272762

### Summary of Invention

### Technical Problem

On installing a surface protective material to a solar cell, the surface protective material is laminated with other members, and they are adhered and integrated through a vacuum lamination process, for example, under conditions of a temperature of from 130 to 180°C and a period of time of from 10 to 40 minutes. The lamination temperature is far higher than the accelerated test disclosed in Patent documents for the ordinary surface protective materials, and thus causes serious damages on the surface protective material. In the use of the protective material for a solar cell in a solar cell module having a compound-based electric generation device that requires a high moisture proof capability and a solar cell module that contains no glass that is required to have flexibility, in particular, it is necessary to prevent deterioration of the moisture proof capability after the accelerated test, in consideration of the influence of the vacuum lamination process.

However, all Patent documents mentioned above do not consider the deterioration of the moisture proof capability of the surface protective material containing a highly moisture proof film having a water vapor permeability of less than 0.1 g/m²·day caused by lamination and integration of the surface protective material with the other members through the vacuum lamination process, and fail to disclose such a surface protective material for a solar cell that maintains a moisture proof capability for a prolonged period of time even after the experience of high temperature conditions of a temperature of from 130 to 180°C and a period of time of from 10 to 40 minutes.

The example of Patent document 1 performs only a test of 85°C and 85% humidity for 1, 000 hrs for a surface protective material for a solar cell, and shows evaluation results after the test, but it is disclosed only that the water vapor permeability after the test was from 1 to 2 g/m²·day. Patent document 2 performs only a pressure cooker test (PCT, severe environmental test under high temperature and high pressure at 105°C for 92 hours)for a surface protective material for a solar cell, and the moisture proofness after the test is evaluated, but it is disclosed only that the water vapor permeability after the test was 0.5 g/m²·day.
Patent documents 3 and 4 disclose evaluation results of the initial moisture proofness of surface protective materials for a solar cell produced through a dry lamination process, but the surface protective materials for a solar cell did not have a sufficient moisture proof capability after the experience of high temperature conditions of a temperature of from 130 to 180°C and a period of time of from 10 to 40 minutes.

Accordingly, an object of the present invention is to provide a highly moisture proof surface protective material for a solar cell having a highly moisture proof film that contains an inorganic thin film layer on one surface of a substrate and has a water vapor permeability of less than 0.1 g/m²·day, in which the surface protective material has excellent moisture proofness without deterioration even after the experience of a high temperature process, such as a vacuum lamination process, and also to provide a solar cell module excellent in durability that contains the surface protective material for a solar cell.

### Solution to Problem

As a result of earnest investigations made by the present inventors, it has been found that a surface protective material for a solar cell satisfies both excellent moisture proofness and interlayer strength simultaneously for a prolonged period of time and realizes durability of the moisture proof capability, by the use of the structure of the surface protective material for a solar cell that contains a highly moisture proof film containing an inorganic thin film layer and having a water vapor permeability of less than 0.1 g/m²·day, having on the side of the inorganic thin film layer thereof a weatherproof film, and having on the opposite side (which may be hereinafter referred to as a back surface) to the inorganic thin film layer of the highly moisture proof film a film that has a particular melting point (hereinafter the film adhered to the back surface of the moisture proof film may be referred to as a back surface film), and thus the prevent invention has been completed.

The present invention relates to:
(1) a surface protective material for a solar cell, containing: a moisture proof film that comprises a substrate having on one surface thereof an inorganic thin film layer and has a water vapor permeability of less than 0.1 g/m²·day; a weatherproof film on a side of the inorganic thin film layer of the moisture proof film; and a back surface film that has a melting point of 80°C or more and 180°C or less on the opposite side of the inorganic thin film layer of the moisture proof film,
(2) the surface protective material for a solar cell according to the item (1), wherein the moisture proof film has a water vapor permeability of 0.05 g/m²·day or less,
(3) the surface protective material for a solar cell according to the item (1), wherein the moisture proof film has a water vapor permeability of 0.01 g/m²·day or less,
(4) the surface protective material for a solar cell according to any one of the items (1) to (3), wherein the back surface film has a melting point of 130°C or more and 180°C or less,
(5) the surface protective material for a solar cell according to any one of the items (1) to (4), wherein the back surface film has a thickness of 25 µm or more and 300 µm or less,
(6) the surface protective material for a solar cell according to any one of the items (1) to (5), wherein the back surface film contains, as a major component, at least one kind of a resin selected from polyethylene, polypropylene, polylactic acid, polyvinyl fluoride and polyvinylidene fluoride,
(7) the surface protective material for a solar cell according to any one of the items (1) to (5), wherein the back surface film is a polypropylene resin film that contains polypropylene as a major component and has an elastic modulus at 23°C of 1,000 MPa or more and a crystallization onset temperature of 120°C or more,
(8) the surface protective material for a solar cell according to any one of the items (1) to (5) and (7), wherein the back surface film is a polypropylene resin film that contains polypropylene as a major component and contains a crystallization nucleating agent in an amount of 0.05 part by mass or more and 5.0 parts by mass or less per 100 parts by mass of the polypropylene,
(9) the surface protective material for a solar cell according to any one of the items (6) to (8), wherein the polypropylene is mainly homopolypropylene,
(10) the surface protective material for a solar cell according to any one of the items (7) to (9), wherein the polypropylene resin film comprises multilayer,
(11) the surface protective material for a solar cell according to any one of the items (1) to (10), wherein the substrate is a polyester resin film,
(12) the surface protective material for a solar cell according to any one of the items (1) to (11), wherein the surface protective material has an adhesive layer between the moisture proof film and the back surface film,
(13) the surface protective material for a solar cell according to any one of the items (1) to (12), wherein the surface protective material has, on the opposite side of the inorganic thin film layer included in the moisture proof film, the back surface film and a plastic film in this order,
(14) the surface protective material for a solar cell according to any one of the items (1) to (13), wherein the surface protective material further comprises an encapsulant material laminated thereon, and
(15) a solar cell module that is produced with the surface protective material for a solar cell according to any one of the items (1) to (14).
In the present invention, the language "X or more and Y or less" may be referred to as "from X to Y" in some cases.

### Advantageous Effects of Invention

Accordingly, the present invention provides a highly moisture proof surface protective material for a solar cell having a highly moisture proof film that contains an inorganic thin film layer on one surface of a substrate and has a water vapor permeability of less than 0.1 g/m²·day, in which the surface protective material has excellent moisture proofness without deterioration even after the experience of a high temperature process, such as a vacuum lamination process, and also provides a solar cell module excellent in durability that contains the surface protective material for a solar cell.

### Description of Embodiments

The present invention will be described in detail below.

### Surface Protective Material

The surface protective material for a solar cell of the present invention contains a highly moisture proof film that comprises a substrate having on one surface thereof an inorganic thin film layer and has a water vapor permeability of less than 0.1 g/m²·day, and the surface protective material contains a weatherproof film on the side of the inorganic thin film layer of the moisture proof film, and a back surface film that has a melting point of 80°C or more and 180°C or less on the back surface of the inorganic thin film layer of the moisture proof film.
The constitutional layers will be described below.

### Weatherproof Film

The surface protective material for a solar cell of the present invention has a weatherproof film laminated on the side of the inorganic thin film layer of the moisture proof film, for providing hydrolysis resistance and light resistance and imparting durability for a prolonged period of time. In the case where the moisture proof film has inorganic thin film layers on both surfaces thereof, the weatherproof film is laminated on the exposure side of the moisture proof film.
The weatherproof film is not particularly limited as far as it has weather resistance, and examples thereof include a fluorine resin film, such as polytetrafluoroethylene (PTFE), a tetrafluoroethylene-perfluoroalkyl vinyl ether copolymer (PFA), a tetrafluoroethylene-hexafluoropropylene copolymer (FEP), a tetrafluoroethylene-ethylene copolymer (ETFE), polychlorotrifluoroethylene (PCTFE), polyvinylidenefluoride (PVDF) and polyvinyl fluoride (PVF), and a film formed of a resin composition containing a resin, such as an acrylic resin, polycarbonate, polyethylene terephthalate (PET) and polyethylene naphthalate (PEN), having a UV absorber mixed therein.

Preferred examples of the resin used include a tetrafluoroethylene-ethylene copolymer (ETFE) and a tetrafluoroethylene-hexafluoropropylene copolymer (FEP) from the standpoint of the long-term durability.
A low shrinkage weatherproof substrate, such as polyethylene naphthalate, is preferred since the property change thereof is preferably small on vacuum lamination and on temperature and humidity change in a high temperature and high humidity environment. A polyethylene terephthalate film and a fluorine film, which have a large shrinkage ratio, are preferably used as the film after subjecting to a treatment for reducing shrinkage, such as a heat treatment, in advance.

In consideration of both the long-term durability and the film shrinkage ratio, preferred examples of the film used include a film formed of a resin composition containing a polyester resin, such as polyethylene terephthalate (PET) and polyethylene naphthalate (PEN), having a UV absorber mixed therein, and a film containing a film formed of a resin composition, such as a polyester resin, provided with a layer containing a UV absorber.
In consideration of application to the protective material for a solar cell, a weatherproof film that is rich in flexibility and has properties excellent in heat resistance, moisture proofness and ultraviolet ray resistance is preferred, and preferred examples thereof used include a fluorine film, a hydrolysis resistant polyester film containing a UV absorber, and a film containing a hydrolysis resistant polyester film provided with a layer containing a UV absorber.

Examples of the UV absorber used include various commercially available products, such as a benzophenone series, a benzotriazole series, a triazine series and a salicylate ester series. Examples of the benzophenone UV absorbers include 2-hydroxy-4-methoxybenzophene, 2-hydroxy-4-methoxy-2'-carboxybenzophenone, 2-hydroxy-4-octoxybenzophenone, 2-hydroxy-4-n-dodecyloxybenzophenone, 2-hydroxy-4-n-octadecyloxybenzophenone, 2-hydroxy-4-benzyloxybenzophenone, 2-hydroxy-4-methoxy-5-sulfobenzophenone, 2-hydroxy-5-chlorobenzophenone, 2,4-dihydroxybenzophenone, 2,2'-dihydroxy-4-methoxybenzophenone, 2,2'-dihydroxy-4,4'-dimethoxybenzophenone and 2,2',4,4'-tetrahydroxybenzophenone.

Examples of the benzotriazole UV absorbers include a hydroxyphenyl-substituted benzotriazole compound, such as 2-(2-hydroxy-5-methylphenyl)benzotriazole, 2-(2-hydroxy-5-t-butylphenyl)benzotriazole, 2-(2-hydroxy-3,5-dimethylphenyl)benzotriazole, 2-(2-methyl-4-hydroxyphenyl)benzotriazole, 2-(2-hydroxy-3-methyl-5-t-butylphenyl)benzotriazole, 2-(2-hydroxy-3,5-di-t-amylphenyl)benzotriazole and 2-(2-hydroxy-3,5-di-t-butylphenyl)benzotriazole. Examples of the triazine UV absorber include 2-(4,6-bis(2,4-dimethylphenyl)-1,3,5-triazin-2-yl)-5-(octy loxy)phenol and 2-(4,6-diphenyl-1,3,5-triazin-2-yl)-5-(hexyloxy)phenol. Examples of the salicylate ester series include phenyl salicylate and p-octylphenyl salicylate.

The amount of the UV absorber added is generally approximately from 0.01 to 2.0% by mass, and preferably from 0.05 to 0.5% by mass, based on the weatherproof film.
Preferred examples of a weathering stabilizer that imparts weather resistance in addition to the UV absorber described above include a hindered amine light stabilizer. A hindered amine light stabilizer does not absorb an ultraviolet ray unlike a UV absorber, but the combination use thereof with a UV absorber exhibits notable synergistic effects.

Examples of the hindered amine light stabilizer include a polycondensate of dimethyl succinate and 1-(2-hydroxyethyl)-4-hydroxy-2,2,6,6-tetramethylpiperidine, poly((6-(1,1,3,3-tetramethylbutyl)amino-1,3,5-triazin-2,4-diyl)(2,2,6,6-tetramethyl-4-piperidyl)imino)hexamethylene( (2,2,6,6-tetramethyl4-piperidyl)imino)), a condensate of N,N'-bis(3-aminopropyl)ethylenediamine and 2,4-bis(N-butyl-N-(1,2,2,6,6-pentamethyl-4-piperidyl)amino )-6-chloro-1,3,5-triazine, bis(2,2,6,6-tetramethyl-4-piperidyl) separate, and bis(1,2,2,6,6-pentamethyl-4-piperidyl) 2-(3,5-di-tert-4-hydroxybenzyl)-2-n-butylmalonate. The amount of the hindered amine light stabilizer added is generally approximately from 0.01 to 0.5% by mass, and preferably from 0.05 to 0.3% by mass, based on the weatherproof film.

The thickness of the weatherproof film is generally approximately from 20 to 200 µm, and is preferably from 20 to 100 µm, and more preferably from 20 to 50 µm, from the standpoint of the handleability and the cost of the film.

### Moisture Proof Film

The moisture proof film in the surface protective material for a solar cell of the present invention is a film that has moisture proofness and comprises a substrate having on at least one surface thereof an inorganic thin film layer formed of an inorganic oxide or the like.
The inorganic thin film layer may protect an inner side of the solar cell from invasion of moisture. When the film having an inorganic layer having high transparency is used as a surface protective material, the electric power generation efficiency may be enhanced.

The substrate having thereon the inorganic thin film layer is preferably a resin film, and any resin that may be used as an ordinary solar cell material may be used as the material therefor without particular limitation. Specific examples thereof include a polyolefin, such as a homopolymer or a copolymer of ethylene, propylene, butene and the like, an amorphous polyolefin, such as a cyclic polyolefin, a polyester, such as a polyethylene terephthalate (PET) and a polyethylene naphthalate (PEN), a polyamide, such as nylon 6, nylon 66, nylon 12 and a copolymer nylon, a partial hydrolysate of an ethylene-vinyl acetate copolymer (EVOH), a polyimide, a polyetherimide, a polysulfone, a polyethersulfone, a polyether ether ketone, a polycarbonate, a polyvinyl butyral, a polyarylate, a fluorine resin, an acrylic resin and a biodegradable resin. Among these, a thermoplastic resin is preferred, and a polyester, a polyamide and a polyolefin are more preferred from the standpoint of the film property, the cost and the like. Among these, a polyester, such as a polyethylene terephthalate (PET) and a polyethylene naphthalate (PEN), is particularly preferred from the standpoint of the film property. In the case where the substrate is a film having a large shrinkage ratio, such as a polyethylene terephthalate film, the advantages of the present invention may be notable due to the large residual strain.

The substrate may contain a known additive, such as an antistatic agent, a UV absorber, a plasticizer, a lubricant, a filler, a colorant, a stabilizer, such as a weathering stabilizer, a lubricating agent, a crosslinking agent, an antiblocking agent and an antioxidant. Examples of the UV absorber and the weathering stabilizer include those described for the weatherproof film.
The resin film as the substrate may be formed by molding the aforementioned materials, and the substrate used may be unstretched or stretched.
The substrate may be a laminated product of one or more kinds of plastic films.

The substrate may be produced by a known method, and for example, an unstretched film that is substantially amorphous and unoriented may be produced by melting and extruding the raw material resin from a circular die or a T-die with an extruder, and then quenched. A single layer film formed of one kind of the resin, a multilayer film formed of one kind of the resin, a multilayer film formed of plural kinds of the resins, and the like may be produced by using a multilayer die.

The unstretched film may be stretched in the machine direction of the film (i.e., the longitudinal axis) or the direction perpendicular to the machine direction of the film (i.e., the transverse axis) by a known method, such as uniaxial stretching, tenter sequential biaxial stretching, tenter simultaneous biaxial stretching and tubular simultaneous biaxial stretching, thereby producing a uniaxially or biaxially stretched film. The stretching ratio may be arbitrarily determined, and the thermal shrinkage at 150°C is preferably from 0.01 to 5%, and more preferably from 0.01 to 2%. Among these, a biaxially stretched polyethylene naphthalate film, a biaxially stretched polyethylene terephthalate film, a biaxially stretched co-extruded film of polyethylene terephthalate and polyethylene naphthalate, and a biaxially stretched co-extruded film of polyethylene terephthalate and/or polyethylene naphthalate with another plastic are preferred.

An anchor coat layer is preferably provided on the substrate by coating an anchor coating agent for enhancing the adhesion to the inorganic thin film layer. Examples of the anchor coating agent include a solvent or aqueous polyester resin, an isocyanate resin, a urethane resin, an acrylic resin, a modified vinyl resin, an alcoholic hydroxyl group-containing resin, such as a vinyl alcohol resin, a vinyl butyral resin, a nitrocellulose resin, an oxazoline group-containing resin, a carbodiimide group-containing resin, a methylene group-containing resin, an epoxy group-containing resin, a modified styrene resin and a modified silicone resin. These may be used solely or as a combination of two or more kinds thereof. The anchor coat layer may contain a silane coupling agent, a titanium coupling agent, a UV absorber, a stabilizer, such as a weathering stabilizer, a lubricant, an antiblocking agent and an antioxidant, depending on necessity. Examples of the UV absorber and the weathering stabilizer include those described for the weatherproof film. A polymer type material, which is obtained by copolymerizing the UV absorber and/or the weathering stabilizer with the aforementioned resin, may also be used.

The method for forming the anchor coat layer may be selected from known coating methods. For example, coating methods using a reverse roll coater, a gravure coater, a rod coater, an air doctor coater and a spray coater may be employed. The substrate may be immersed in a resin solution. After coating, the solvent may be evaporated by a known drying method, such as a heat drying method, e.g., hot air drying at a temperature of approximately from 80 to 200°C and heat roll drying, and an infrared ray drying method. The anchor coat layer may be crosslinked by irradiation with an electron beam for enhancing the water resistance and the durability. The formation of the anchor coat layer may be performed on the production line of the substrate (i.e., an in-line method) or after the production of the substrate (i.e., an off-line method).
The thickness of the anchor coat layer is preferably from 10 to 200 nm, and more preferably from 10 to 100 nm, from the standpoint of the adhesion to the inorganic thin film layer.

The method for forming the inorganic layer may be such a method as a vapor deposition method and a coating method, and a vapor deposition method is preferred since a uniform thin film having high gas barrier property may be obtained thereby. Examples of the vapor deposition method include a physical vapor deposition (PVD) method and a chemical vapor deposition (CVD) method. Examples of the physical vapor deposition method include vacuum vapor deposition, ion plating and sputtering, and examples of the chemical vapor deposition method include plasma CVD using plasma and catalytic chemical vapor deposition (Cat-CVD), in which a raw material gas is subjected to catalytic thermal decomposition with a heating catalyst body.

Examples of the inorganic substance constituting the inorganic thin film layer include silicon, aluminum, magnesium, zinc, tin, nickel, titanium and hydrogenated carbon, an oxide, a carbonate and a nitrate thereof, and mixtures thereof, and silicon oxide, aluminum oxide and diamond-like carbon containing mainly hydrogenated carbon are preferred. In particular, silicon oxide, silicon nitride, silicon oxynitride and aluminum oxide are preferred since high gas barrier property may be stably maintained.

The thickness of the inorganic thin film layer is preferably from 10 to 1, 000 nm, more preferably from 40 to 1, 000 nm, further preferably from 40 to 800 nm, and particularly preferably from 50 to 600 nm, for enhancing the moisture proof capability stably. The inorganic layer may have a single layer structure or a multilayer structure.
The thickness of the substrate film is generally approximately from 5 to 100 µm, and is preferably from 8 to 50 µm, and more preferably from 12 to 25 µm, from the standpoint of the productivity and the handleability. Accordingly, the thickness of the moisture proof film is generally approximately from 5 to 100 µm, and is preferably from 8 to 50 µm, and more preferably from 12 to 25 µm, from the standpoint of the productivity and the handleability.
In the moisture proof film that has high moisture proofness, the moisture proof capability may be largely deteriorated by the stress from the back surface film, and thus the effect of maintaining the moisture proofness of the present invention may be notably exhibited. Accordingly, in the present invention, the moisture proof film may have a water vapor permeability of less than 0.1 g/m²·day, preferably 0.05 g/m²·day or less, more preferably 0.03 g/m²·day or less, and particularly preferably 0.01 g/m²·day or less.

### Back Surface Film

In the present invention, the back surface film used is a film having a melting point of 80°C or more and 180°C or less, and preferably a film having a melting point of 130°C or more and 180°C.
In general, the surface protective material for a solar cell is produced through a lamination process by dry lamination of the constitutional members including the weatherproof film, the moisture proof film and the back surface film. In the dry lamination process, an adhesive having been diluted with a solvent is coated to a prescribed thickness on the film, such as the weatherproof film, from which the solvent is evaporated by drying at a temperature in a range of from 100 to 140°C to form an adhesive layer on the film, such as the weatherproof film, and then the inorganic thin film layer of the moisture proof film is adhered to the adhesive layer. Thereafter, an adhesive having been diluted with a solvent is coated to a prescribed thickness on the back surface of the moisture proof film, from which the solvent is evaporated by drying at a temperature in a range of from 100 to 140°C to form an adhesive layer on the moisture proof film, as similar to the above. The back surface film is then adhered thereto, and the assembly is subjected to aging at a prescribed temperature, thereby producing the surface protective material. The aging is generally performed at a temperature in a range of from 30 to 80°C for a period of from one day to one week, and in this lamination process, residual strain is accumulated in the surface protective material through action of the heat and the tension on lamination.

Subsequently, the surface protective material is integrated with a solar cell device and an encapsulant material by melting under heat through a vacuum lamination process, thereby fabricating a solar cell. The vacuum lamination process is generally performed at a temperature in a range of from 130 to 180°C.
The residual strain accumulated in the lamination process acts as a stress to the respective interfaces of the laminated material in the use of the solar cell under a high temperature and high humidity environment. In the case where the residual strain is accumulated in the back surface film, a stress is applied to the inorganic thin film layer from the back surface side under a high temperature and high humidity environment, and the inorganic thin film layer suffers severe deterioration. In particular, a moisture proof film having a high moisture proofness with a water vapor permeability of less than 0.1 g/m²·day, which is the target of the present invention, suffers particularly severe deterioration of the moisture proof capability due to the deterioration of the inorganic thin film layer caused by the stress from the back surface film.

However, the use of a film having a melting point near the temperature in the vacuum lamination process, i.e., the use of a film having a melting point of 180°C or less, as the back surface film reduces, in the vacuum lamination process, the residual strain caused by the stress history and the thermal history applied in the preceding process steps, and thus the stress acting on the inorganic thin film layer of the moisture proof film under a high temperature and high humidity environment, thereby preventing the moisture proof capability from being deteriorated. The melting point is preferably 175°C or less, and more preferably 170°C or less.

The lower limit of the melting point of the back surface film is 80°C, preferably 130°C, more preferably 140°C, and particularly preferably 150°C, for preventing deterioration of the uniformity of the film due to increase of the flowability of the back surface film layer on application of pressure and heat in the vacuum lamination process and for achieving the heat resistance at the working temperature of the solar cell of from 80 to 100°C.

The back surface film preferably does not have any other film that does not have a melting point of 80°C or more and 180°C or less between the moisture proof film and the back surface film.
The thickness of the back surface film is preferably 25 µm or more, and more preferably 50 µm or more, from the standpoint of the handleability of the film, and is further preferably 90 µm or more since a larger thickness is desired for ensuring partial discharge of the protective material. The total thickness of the film that has been ordinarily disposed on the back surface of the moisture proof film has been demanded to be larger for ensuring partial discharge of the surface protective material. However, the larger thickness increases the residual strain accumulated in the production process of the surface protective material, and thus the thickness has been limited for preventing the severe deterioration of the moisture proof capability. In the present invention, the use of the film having a melting point in the aforementioned range as the back surface film enables that the back surface film having a thickness of 90 µm or more may be used in the surface protective material by preventing the moisture proof capability from being deteriorated. The thickness of the back surface film is preferably 300 µm or less, more preferably 250 µm or less, and further preferably 200 µm or less, from the standpoint of the economical efficiency. For the back surface film that has a lower melting point, such as the back surface film having a melting point of 80°C or more and less than 130°C, the flowability of the back surface film layer may be larger on application of pressure and heat in the vacuum lamination process, which may impair the uniformity of the film, and therefore the thickness of the film is preferably 100 µm or less, more preferably 80 µm or less, and particularly preferably 50 µm or less.
The melting point herein is a value that is measured by the method described in the examples later.

In consideration of the above, the back surface film used is preferably a film formed of a resin composition, such as polypropylene (PP), polylactic acid (PLA), polyvinyl fluoride (PVF), polyvinylidene fluoride (PVDF), cellulose acetate butyrate and polyethylene such as low density polyethylene (LDPE), but is not limited thereto. A film formed of a resin composition having a UV absorber and a colorant mixed therein may also be used.

In consideration of application to the surface protective material for a solar cell, the back surface film is preferably rich in flexibility and excellent in ultraviolet ray resistance and humidity resistance, and thus the back surface film preferably contains, as a major component, one resin or plural resins selected from polypropylene (PP), polylactic acid (PLA), polyvinyl fluoride (PVF) and polyvinylidene fluoride (PVDF), and preferably contains these resins in an amount of 50% by mass or more. The term "major component" herein means that other components may be contained in such a range that does not impair the advantages of the present invention, but does not limit the content specifically, and generally means a range of 50 parts by mass or more, preferably 65 parts by mass or more, and more preferably 80 parts by mass or more, and 100 parts by mass or less, per 100 parts by mass of the total amount of the constitutional components of the film layer.

The back surface film that contains polypropylene as a major component is preferably a polypropylene resin film having an elastic modulus at 23°C of 1, 000 MPa or more, having a crystallization onset temperature of 120°C or more, and/or containing a crystallization nucleating agent in an amount of 0.05 part by mass or more and 5.0 parts by mass or less per 100 parts by mass of the polypropylene resin. When the content of the crystallization nucleating agent is in the range, the crystallization onset temperature may be sufficiently maintained with the crystallization nucleating agent, and thus the protective material for a solar cell may have a favorable appearance. The content of the crystallization nucleating agent is more preferably 0.1 part by mass or more and 1.0 parts by mass or less per 100 parts by mass of the polypropylene resin.
The elastic modulus at 23°C is preferably 1,000 MPa or more, and more preferably 1,200 MPa or more, for exhibiting high deformation resistance in a semi-molten state, which may prevents deformation and appearance defects, such as wrinkles and protrusions.

The elastic modulus at 23°C herein is a value that is measured by the method described in the examples later.
The method for attaining the elastic modulus at 23°C of 1,000 MPa or more is not particularly limited, and examples thereof include a method of increasing the crystallization degree of polypropylene by adding a crystallization nucleating agent, and a method of adding an inorganic agent, such as talc, to polypropylene.
As the polypropylene resin constituting the polypropylene resin film, any of a propylene homopolymer and a copolymer thereof, such as an ethylene-propylene random copolymer, may be used, and homopolypropylene is preferred since the crystallization onset temperature and the crystallization rate may be increased along with by the addition of the crystallization nucleating agent, and simultaneously a polypropylene resin film having a high elastic modulus may be provided.

In the present invention, the polypropylene resin film preferably has a crystallization onset temperature of 120°C or more for forming minute crystals on cooling in the cooling process after the vacuum lamination process, thereby exhibiting high deformation resistance in a semi-molten state, which may prevents deformation and appearance defects, such as wrinkles and protrusions. In this point of view, the crystallization onset temperature is preferably 125°C or more, and more preferably the vacuum lamination temperature or more and 180°C or less.
The crystallization onset temperature of the polypropylene resin film is a value that is measured by the method described in the examples later.

Examples of the method for attaining the crystallization onset temperature of 120°C or more include a method of increasing the stereoregularity of polypropylene, and a method of using a crystallization nucleating agent is effectively employed. The use of the crystallization nucleating agent not only increases the crystallization temperature, but also increases the crystallization rate, thereby imparting deformation resistance against shrinkage of the other films to the polypropylene resin film more rapidly in the cooling process after the vacuum lamination process.

The crystallization nucleating agent capable of being used in the present invention may be arbitrary organic substance or inorganic substance that has a nucleating effect of increasing the crystallization rate. Specific examples of the organic nucleating agent include a dibenzylidene sorbitol compound and a phosphate compound.

Examples of the dibenzylidene sorbitol compound include dibenzylidene sorbitol (which may be abbreviated as DBS), p-methyl-DBS, p-ethyl-DBS and p-chloro-DBS. Examples of the phosphate compound include bis (2,4,8,10-tetra-tert-butyl-6-hydroxy-12H-dibenzo[d.g] [1 ,3,2]dioxaphosphosine-6-oxide) aluminum hydroxide salt.
Examples of the organic nucleating agent also include an organic metal compound, such as aluminum dibenzoate, basic aluminum di-p-tert-butylbenzoate, sodium β-naphthoate, sodium 1,2-cyclohexanedicarboxylate, sodium succinate, sodium gluconate, sodium caproate and 2,2-methylenebis(4,6-di-tert-butylphenyl) sodium phosphate, and phthalocyanine, quinacridone and a high melting point polymer may also be used. Specific examples of the inorganic nucleating agent include alum and titanium.

According to the aforementioned embodiment, the crystallization nucleating agent contained may maintain the light reflectance of the polypropylene resin film even after the vacuum lamination process, and thus the film may be more preferably applied to the protective material for a solar cell.

The increase of the crystallization onset temperature and the increase of the crystallization rate caused by adding the crystallization nucleating agent to the homopolypropylene increase the crystallization degree and increase the crystal size in the polypropylene resin film thus produced, and thereby the polypropylene resin film that has a higher elastic modulus may be obtained simultaneously. For providing the polypropylene resin film having a further higher elastic modulus, an inorganic filler may be added to the polypropylene resin film in such a range that does not lower the reflectivity. Examples of the inorganic filler capable of being used herein include a white inorganic filler, such as mica and barium sulfate.

The polypropylene resin film may be formed of a single layer solely or may comprises multilayer including two or more layers, and for ensuring the adhesion to an encapsulant material and satisfying the elastic modulus and the crystallization onset temperature referred in the present invention, the polypropylene resin film preferably comprises multilayer, and more preferably formed of two layers.
For enhancing the adhesion to an encapsulant material in the vacuum lamination process, the polypropylene resin film used is preferably a multilayer polypropylene resin film that contains at least two layers including a layer formed of polypropylene containing an ethylene-propylene random copolymer on the side of the encapsulant material, and a layer formed of homopolypropylene for satisfying the elastic modulus and the crystallization onset temperature. In this case, the ratio in thickness of the ethylene-propylene random copolymer resin layer on the side of the encapsulant material and the homopolypropylene resin layer ((ethylene-propylene random copolymer resin layer) / (homopolypropylene resin layer)) is preferably from (0.01/0.99) to (0.30/0.70), and is more preferably from (0.05/0.95) to (0.25/0.75) for further enhancing the adhesion to the encapsulant material.

Examples of the UV absorber contained in the back surface film include the same UV absorbers contained in the weatherproof film described above. Examples of the colorant used include titanium oxide and calcium carbonate.
The back surface film may contain the components within the melting point range solely or may contain the components in an amount of 50% by mass or more unless the melting point deviates the aforementioned range.

### Plastic Film

The surface protective material for a solar cell of the present invention may further contain a plastic film through the back surface film on the opposite side of the moisture proof film from the inorganic thin film layer, for enhancing the withstand voltage capability and the handleability of the surface protective material. As the plastic film, the same materials as the back surface film or other materials may be used, and polypropylene and polyethylene terephthalate (PET) are preferably used from the standpoint of the adhesion to an encapsulant material and the reflectivity.

In the present invention, a polyester film and a fluorine film that are described for the weatherproof film may also be laminated as the plastic film for enhancing the elastic modulus and the rigidity of the total surface protective material for a solar cell.

The plastic film preferably has a thickness of 10 µm or more, and more preferably 20 µm or more, for suppressing the influence on the deterioration of the moisture proofness and ensuring the strength as the layer adhered to an encapsulant material. The thickness thereof is preferably 100 µm or less, and more preferably 50 µm or less, for further reducing the residual strain accumulated in the production process of the surface protective material.

### Surface Protective Material

The surface protective material for a solar cell of the present invention contains, as described above, the moisture proof film having on the exposure side the weatherproof film for attaining the hydrolysis resistance and the light resistance, and on the side of the solar cell device the back surface film for ensuring the adhesion to an encapsulant material and the withstand voltage, and may further have the plastic film. Thus, the weatherproof film, the moisture proof film and the back surface film (and the plastic film) are preferably laminated in this order from the exposure side. The weatherproof film, the moisture proof film and the back surface film, and the plastic film provided depending on necessity are each preferably laminated through adhesive layers formed of an adhesive, for ensuring the interlayer strength of the laminated material.
In particular, the moisture proof film and the back surface film is preferably adhered through an adhesive layer.

The adhesive used is preferably a polyurethane adhesive, and specific examples of the main agent of the adhesive include compositions containing polycarbonate polyol, polyether polyol, acrylic polyol, polyurethane polyol and polyester polyol. An adhesive containing at least one of polycarbonate polyol, polyether polyol and polyurethane polyol is more preferred from the standpoint of the thermal stability, the moisture stability and the like.

The surface protective material for a solar cell of the present invention may have a sealant-surface protective material integrated structure having the encapsulant material described later laminated. The encapsulant material that has been laminated in advance may reduce the work load on laminating the lower protective sheet (i.e., the back surface protective sheet), the encapsulant material, the solar cell device, the encapsulant material and the upper protective sheet (i.e., the front surface protective sheet) respectively in the vacuum lamination process, thereby improving the efficiency in the production of the solar cell module.

The surface protective material for a solar cell of the present invention may contain, for example, various elastomers (such as an olefin series and a styrene series), a resin modified with a polar group, such as a carboxyl group, an amino group, an imide group, a hydroxyl group, an epoxy group, an oxazoline group, a thiol group and a silanol group, and a tackiness imparting resin, for enhancing the various properties (such as the flexibility, the heat resistance, the transparency and the adhesiveness), the molding processability, the economical efficiency and the like, in such a range that does not deviate the substance of the present invention. The back surface film may contain these resins as far as the melting point range is satisfied.

Examples of the tackiness imparting resin include a petroleum resin, a terpene resin, a coumarone-indene resin, a rosin resin, and hydrogenated derivatives of these resins. Specifically, examples of the petroleum resin include an alicyclic petroleum resin formed of cyclopentadiene or a dimer thereof, and an aromatic petroleum resin formed of a C9 component, examples of the terpene resin include a terpene resin formed of β-pinene and a terpene-phenol resin, and examples of the rosin resin include such rosin resins as gum rosin and wood rosin, and an esterified rosin resin modified with glycerin, pentaerythritol or the like. The tackiness imparting resin may have various softening temperatures depending mainly on the molecular weight thereof. The tackiness imparting resin is preferably a hydrogenated derivative of an alicyclic petroleum resin having a softening temperature of from 100 to 150°C, and more preferably from 120 to 140°C. The amount thereof is preferably 20% by mass or less, and more preferably 10% by mass or less, per 100% by mass of the resin composition forming the respective films constituting the surface protective material.

The surface protective material for a solar cell may contain various additives, such as the UV absorber and the weathering stabilizer described above, depending on necessity. Examples of the additive include a silane coupling agent, an antioxidant, a light diffusing agent, a nucleating agent, a pigment (such as a white pigment), a flame retardant and a discoloration preventing agent. In the present invention, at least one additive selected from a silane coupling agent, an antioxidant, a UV absorber and a weathering stabilizer. A crosslinking agent and/or crosslinking assistant may be added in the case where high heat resistance is required.

Examples of the silane coupling agent include compounds having an unsaturated group, such as a vinyl group, an acryloxy group and a methacryloxy group, an amino group, an epoxy group and the like, along with a hydrolyzable group, such as an alkoxy group. Specific examples of the silane coupling agent include N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane and γ-methacryloxypropyltrimethoxysilane. In the present invention, γ-glycidoxypropyltrimethoxysilane and γ-methacryloxypropyltrimethoxysilane are preferably used since good adhesiveness may be obtained, and less discoloration, such as yellowing, may occur. The amount of the silane coupling agent added is generally approximately from 0.1 to 5% by mass, and preferably from 0.2 to 3% by mass, based on the respective films constituting the surface protective material. A coupling agent, such as an organic titanate compound, may also be used as similar to the silane coupling agent.

The antioxidant used includes various commercially available products, and examples thereof include a monophenol series, a bisphenol series, a polymer phenol series, a sulfur series and a phosphite series. Examples of the monophenol series include 2,6-di-tert-butyl-p-cresol, butylated hydroxyanisole and 2,6-di-tert-butyl-4-ethylphenol. Examples of the bisphenol series include 2,2'-methylenebis(4-methyl-6-tert-butylphenol), 2,2'-methylenebis(4-ethyl-6-tert-butylphenol), 4,4'-thiobis(3-methyl-6-tert-butylphenol), 4,4'-butylidenebis(3-methyl-6-tert-butylphenol) and 3,9-bis((1,1-dimethyl-2-(β-(3-tert-butyl-4-hydroxy-5-methy 1phenyl)propionyloxy)ethyl)-2,4,9,10-tetraoxaspiro)-5,5-un decane.

Examples of the polymer phenol series include 1,1,3-tris(2-methyl-4-hydroxy-5-tert-butylphenyl)butane, 1,3,5-trimethyl-2,4,6-tris(3,5-di-tert-butyl-4-hydroxybenz yl)benzene, tetrakis(methylene-3-(3',5'-di-tert-butyl-4'-hydroxyphenyl )propionate)methane, bis((3,3'-bis-4'-hydroxy-3'-tert-butylphenyl)butyric acid) glycol ester, 1,3,5-tris(3',5'-di-tert-butyl-4'-hydroxybenzyl)-s-triazin -2,4,6-(1H,3H,5H)trione and triphenol(vitamin E).
Examples of the sulfur series include dilaurylthiodipropionate, dimyristylthiodipropionate and distearylthipropionate.

Examples of the phosphite series include triphenyl phosphite, diphenyl isodecyl phosphite, phenyl diisodecyl phosphite, 4,4'-butylidene-bis(3-methyl-6-tert-butylphenylditridecyl) phosphite, cyclic neopentantetraylbis(octadecyl phosphite), tris(mono and/or di)phenyl phosphite, diisodecyl pentaerythritol diphosphite, 9,10-dihydro-9-oxa-10-phosphaphenanthrene-10-oxide, 10-(3,5-di-tert-butyl-4-hydroxybenzyl)-9,10-dihydro-9-oxa-10-phosphaphenanthrene-10-oxide, 10-decyloxy-9,10-dihydro-9-oxa-10-phsophaphenanthrene, cyclic neopentantetraylbis(2,4-di-tert-butylphenyl) phosphite, cyclic neopentantetraylbis(2,6-di-tert-methylphenyl) phosphite and 2,2-methylenebis(4,6-tert-butylphenyl) octyl phosphite.

In the present invention, the phenol antioxidant and the phosphite antioxidant are preferably used, and the combination use thereof is more preferred, from the standpoint of the effect, the heat stability, the economical efficiency and the like of the antioxidant. The amount of the antioxidant added is generally approximately from 0.1 to 1% by mass, and preferably from 0.2 to 0.5% by mass, based on each of the films constituting the surface protective material for a solar cell.

The method for forming the respective films constituting the surface protective material for a solar cell used in the present invention may be a known method, such as an extrusion casting method using a T-die with a melt-mixing apparatus, such as a single screw extruder, a multi-screw extruder, a Banbury mixer and a kneader, and a calendering method, but the method is not particularly limited thereto. In the present invention, an extrusion casting method using a T-die is preferably employed from the standpoint of the handleability and the productivity. The molding temperature in the casting method using a T-die may be controlled depending on the flow property, the film forming property and the like of the resin composition used, and is generally approximately from 130 to 350°C, and preferably from 250 to 300°C. The additives may be dry-mixed with the resin in advance and then fed to a hopper, all the materials may be melt-mixed and formed into pellets, which may be fed to a hopper, or a master batch containing the additives in a high concentration may be produced in advance and then fed to a hopper.

The thus obtained surface protective material for a solar cell of the present invention using the highly moisture proof film having a water vapor permeability of less than 0.1 g/m²·day preferably has an initial moisture proof capability, which is the moisture proof capability of the surface protective material (laminated moisture proof film) for a solar cell before heat treatment, of 0.1 g/m²·day or less, and more preferably 0.05 g/m²·day or less, in terms of water vapor permeability. The surface protective material for a solar cell of the present invention may be used as a surface protective material and the like for an electronic device that is required to have excellent moisture proof capability, and the use of the laminated moisture proof film having an excellent initial moisture proof capability is preferred since the advantageous effects of the present invention may be exhibited notably. The moisture proof capability thereof is preferably 20 or less, and more preferably 15 or less, in terms of the deterioration rate after subjecting to a pressure cooker test of 120°C and a humidity of 100% for 32 hours with respect to the initial water vapor permeability of the laminated moisture proof film.

In the case where a polyurethane adhesive is used as the adhesive, when the adhesive is decomposed under the high temperature and high humidity conditions to form a carboxylic acid and a hydroxyl group, it is considered that the functional groups form a chemical bond with the inorganic thin film layer to deteriorate the inorganic thin film layer. Accordingly, the polyol contained in the polyurethane adhesive is preferably polycarbonate polyol, polyether polyol, polyacryl polyol, polyurethane polyol and the like, which are excellent in heat resistance, rather than polyester polyol, which is liable to be thermally decomposed.
In the present invention, the deterioration rate of the moisture proofness (water vapor permeability) after subjecting to a pressure cooker test is expressed by ( (b-a) /a) with the initial water vapor permeability (a) and the water vapor permeability (b) after the pressure cooker test.

The initial moisture proof capability of the surface protective material for a solar cell of the present invention means the moisture proof capability before the material receives the thermal history with a high temperature, such as the vacuum lamination condition, and thus means the value before the deterioration of the moisture proof capability due to heat occurs. Accordingly, it includes the time-lapse change immediately after the production until the heat treatment. For example, it means the value of the moisture proof capability in such a state that the heat treatment, such as a thermal lamination process performed at from 130 to 180°C for from 10 to 40 minutes, is not yet performed. For the initial water vapor permeability, the term "initial" has the same meaning as above.
The moisture proof capability may be evaluated according to the conditions of JIS Z0222, test method for moisture permeability for moisture proof packaging container, and JIS Z0208, test method for moisture permeability for moisture proof packaging material (cup method).

The surface protective material of the present invention preferably has an interlayer strength of 4 N/15 mm or more in terms of a value after a pressure cooker test at 120°C and a humidity of 100% for 32 hours. The interlayer strength is more preferably 7.0 mm or more, further preferably 7.3 mm or more, still further preferably 7.5 N/15 mm or more, still further preferably 8 N/15 mm or more. In particular, the interlayer strength after subjecting to a high temperature and high humidity treatment for producing a solar cell module is preferably 4 N/15 mm or more, more preferably 7.0 mm or more, further preferably 7.3 mm or more, and particularly preferably 7.5 N/15 mm or more.
The interlayer strength herein is a value that is measured by the method described in the examples later.

### Production Method of Surface Protective Material

The production method of the surface protective material for a solar cell of the present invention is not particularly limited, and the surface protective material may be produced, for example, in such a manner that the films thus formed as described above are coated with a polyurethane adhesive, which is dried at a temperature of from 100 to 140°C, and the films are adhered through a dry lamination process at a temperature of from 0 to 80°C. In this case, the resulting laminated material is preferably subjected to aging at a temperature of from 30 to 80°C for from 1 to 7 days for making the adhesive to reach the saturated crosslinking degree sufficiently. The surface protective material of the present invention thus obtained is excellent in flexibility and moisture proofness with no deterioration in moisture proofness and interlayer strength even after subjecting to the dry lamination process.

The surface protective material for a solar cell of the present invention preferably has partial discharge resistance, in addition to the weather resistance and the moisture proofness. Specifically, in a partial discharge resistance test for measuring the withstand voltage where the surface protective member reaches dielectric breakdown, the surface protective material preferably has a withstand voltage of from 700 to 1,000 V as a protective material for a solar cell.
The thickness of the surface protective material is not particularly limited and is generally approximately from 100 to 400 µm, preferably approximately from 100 to 300 µm, more preferably approximately from 140 to 300 µm, and further preferably approximately from 180 to 260 µm, and the surface protective material may be used in the form of a sheet.

The surface protective material generally preferably has a thickness of from 180 to 230 µm for achieving the aforementioned withstand voltage characteristics while it may vary depending on the demanded withstand voltage. The thicknesses of the respective layers for achieving the thickness may be determined arbitrarily, and examples thereof include a constitution, in which the weatherproof film and the moisture proof film, which are relatively expensive, each have a thickness of from 10 to 50 µm, the adhesive has a thickness of from 4 to 10 µm, the back surface film has a thickness of from 50 to 100 µm, and the plastic film has a thickness of from 50 to 150 µm, and also include a constitution in consideration of the productivity of the moisture proof film and the productivity in the dry lamination process, in which the weatherproof film and the moisture proof film each have a thickness of from 12 to 30 µm, the adhesive has a thickness of from 4 to 8 µm, the back surface film has a thickness of from 50 to 100 µm, and the plastic film has a thickness of from 70 to 120 µm.

### Solar Cell Module and Production Method of Solar Cell

The surface protective material of the present invention may be used as a surface protective member for a solar cell, as it is or after laminating with a glass plate or the like. A solar cell module and/or a solar cell may be produced by using the surface protective material of the present invention according to a known method.

A solar cell module may be produced by using the surface protective material of the present invention in a layer structure of a surface protective material, such as an upper protective material or a lower protective material for a solar cell, and fixing them with a solar cell device along with an encapsulant material. Examples of the solar cell module include various types, for example, a structure containing an upper protective material (the surface protective material of the present invention) / an encapsulant material (a sealing resin layer) / a solar cell device / an encapsulant material (a sealing resin layer) / a lower protective material; a structure containing an upper protective material / an encapsulant material (a sealing resin layer) / a solar cell device / an encapsulant material (a sealing resin layer) / a lower protective material (the surface protective material of the present invention); a structure containing a lower protective material, a solar cell device formed on the inner surface of the lower protective material, and an encapsulant material and an upper protective material (the surface protective material of the present invention) formed on the solar cell device; and a structure containing an upper protective material (the surface protective material of the present invention) and a solar cell device formed on the inner surface of the upper protective material, for example, an amorphous solar cell device formed by sputtering or the like on a fluorine resin protective material, and an encapsulant material and a lower protective material formed thereon. A glass plate may be arbitrarily adhered to the outer surface of the surface protective material of the present invention as the upper protective material. In the case where the surface protective material including the encapsulant material and the surface protective material integrated is used, the encapsulant material may not be used in some cases.

Examples of the solar cell device include a device of a single crystal silicon type, a polycrystalline silicon type and an amorphous silicon type, a compound semiconductor device, such as a III-V Group or II-VI Group compound semiconductor type, e.g., gallium-arsenic, copper-indium-selenium and cadmium-tellurium, a dye sensitized device, and an organic thin film device.

The members constituting the solar cell module produced by using the surface protective material of the present invention are not particularly limited, and examples of the encapsulant material include an ethylene-vinyl acetate copolymer. The upper protective material and the lower protective material other than the surface protective material of the present invention may be a single layer or multilayer sheet of an inorganic material, such as a metal, or various thermoplastic resin films, and examples thereof include a single layer or multilayer protective material of a metal, such as tin, aluminum and stainless steel, an inorganic material, such as glass, a polyester, a polyester having an inorganic material vapor-deposited thereon, a fluorine-containing resin, a polyolefin or the like. The surface of the upper and/or lower protective materials may be subjected to a known surface treatment, such as a primer treatment and a corona treatment, for enhancing the adhesiveness to the encapsulant material and the other members.

The solar cell module produced by using the surface protective material of the present invention will be described with reference to a structure described above containing an upper protective material (the surface protective material of the present invention) / an encapsulant material / a solar cell device / an encapsulant material / a lower protective material, as an example. The surface protective material of the present invention, the sealing resin layer, the solar cell device, the sealing resin layer and the lower protective material are laminated in this order from the side receiving the solar light, and a junction box (i.e., a terminal box connected to wiring for extracting the electric power generated by the solar cell device to the outside) is adhered to the lower surface of the lower protective material. The solar cell device is connected to wiring for extracting the generated electric current to the outside. The wiring is drawn to the outside via a through hole provided on the back sheet and connected to the junction box.

The production method of the solar cell module may be a known production method without particular limitation, and in general, contains a step of laminating the upper protective material, the encapsulant material, the solar cell device, the encapsulant material and the lower protective material in this order, and a step of adhering them under heat and pressure by vacuum drawing. A batch production equipment and a roll-to-roll production equipment may be applied. Specifically, the solar cell module may be easily produced by adhering the upper protective material, the encapsulant material, the solar cell device, the encapsulant material and the lower protective material under heat and pressure according to an ordinary method with a vacuum laminator preferably at a temperature of from 130 to 180°C, and more preferably from 130 to 150°C, a vacuuming time of from 2 to 15 minutes, a pressing pressure of from 0.5 to 1 atm, and a pressing time of preferably from 8 to 45 minutes, and more preferably from 10 to 40 minutes.

The solar cell module produced by using the surface protective material of the present invention may be applied, depending on the type of the solar cell and the shape of the module, to various purposes including a small size solar cell, such as for a mobile equipment, and a large size solar cell mounted on a roof or a house top, irrespective of indoor or outdoor use.

### Example

The present invention will be described more specifically with reference to examples below, but the present invention is not limited to the examples and comparative examples. The measurement and evaluation of the properties were performed in the following manners.

### Measurement of Properties

### (1) Crystal Melting Peak Temperature of Back Surface Film (Melting Point, Tm)

According to JIS K7121 and using a differential scanning calorimeter, Q20, produced by TA Instruments, Ltd., 10 mg of a specimen was heated from -40°C to 200°C at a heating rate of 10°C per minute, confirmed for a melting peak, maintained at 200°C for 1 minute, then cooled to -40°C at a cooling rate of 10°C per minute, and again heated to 200°C at a heating rate of 10°C per minute, thereby providing a thermogram, in which the maximum peak among the crystal melting peak temperatures was designated as the melting point (Tm) (°C). In the case where no melting peak was observed due to a melting point exceeding 200°C as in polyester or the like, the same measurement was performed with the upper limit temperature on heating of 300°C.

### (2) Crystallization Onset Temperature

According to JIS K7121 and using a differential scanning calorimeter, approximately 10 mg of a film specimen to be measured was heated from -40°C to 200°C at a heating rate of 10°C per minute, confirmed for a melting peak, maintained at 200°C for 1 minute, and then cooled to -40°C at a cooling rate of 10°C per minute, thereby providing a thermogram, in which the onset temperature of the maximum peak was designated as the crystallization onset temperature (Tc) (°C). In the case where no melting peak was observed due to a melting point exceeding 200°C as in polyester or the like, the same measurement was performed with the upper limit temperature on heating of 300°C.

### (3) Elastic Modulus

According to JIS K6734:2000, a specimen was formed into a dumbbell specimen for tensile test having a width of the parallel portion of 10 mm and a length thereof of 40 mm, which was subjected to a tensile test according to JIS K7161:1994, and the measured value was designated as the elastic modulus.

### (4) Pressure Cooker Test

A specimen was subjected to a pressure cooker test by using a pressure cooker tester, LSK-500, produced by Tomy Seiko Co., Ltd., under test conditions of a temperature of 120°C and a humidity of 100% for 32 hours.

### (5) Moisture Proof Capability of Moisture Proof Film and Surface Protective Material

The moisture proof capability of the moisture proof film was measured in terms of the water vapor permeability at the time after storing at 40°C for one week from the production of the moisture proof film, by the following manner. For the surface protective material, the measured value for the surface protective material after adhering the constitutional films and aging was designated as the initial water vapor permeability. The surface protective material after subjecting to the aging was laminated with glass and an encapsulant material (where the back surface of the moisture proof film was directed to the side of an encapsulant material), and the laminated material was subjected to a heat treatment under conditions of 150°C for 30 minutes and then subjected to the pressure cooker test, and the water vapor permeability of the surface protective material thereafter was designated as the value of moisture proofness after the pressure cooker test.
Specifically, the evaluation was performed in the following manner according to the conditions of JIS Z0222, test method for moisture permeability for moisture proof packaging container, and JIS Z0208, test method for moisture permeability for moisture proof packaging material (cup method).
Two sheets of the specimens each having a moisture permeation area of a square of 10.0 cm × 10.0 cm were used, and a bag having been sealed on the four edges thereof containing approximately 20 g of anhydrous calcium chloride as a desiccant was produced. After placing the bag in a constant temperature and humidity chamber at a temperature of 40°C and a relative humidity of 90%, the mass thereof was measured with an interval of 72 hours or more for approximately 200 days, and the water vapor permeability (g/m²·day) was calculated from the regression line of the elapsed time after 4 days and the weight of the bag. The deterioration rate of the water vapor permeability was calculated by the expression ((water vapor permeability after pressure cooker test)-(initial water vapor permeability)) / (initial water vapor permeability).

### (6) Measurement of Interlayer Strength of Surface Protective Material

The surface protective material after subjecting to the aging was subjected to a heat treatment under conditions of 150°C for 30 minutes and then subjected to the pressure cooker test, according to the aforementioned manner, and then a short strip specimen having a measurement width of 15 mm was cut out therefrom and measured for the interlayer lamination strength (N/15 mm) between the weatherproof film and the moisture proof film by using a tensile tester, STA-1150, produced by Orientec Co., Ltd., at 300 mm/min.

### (7) Heat Resistance

The surface protective material was superimposed between two white glass plates each having a thickness of 3 mm (size: 75 mm in length × 25 mm in width), which were laminated by pressing under conditions of 150°C for 15 minutes, thereby preparing a specimen, and the specimen was placed with inclination of 60° in a thermostat chamber at 100°C, observed for the state after 500 hours, and evaluated according to the following standard.
A: The glass plate was not deviated from the initial reference position.
B: The glass plate was deviated from the initial reference position, or the sheet was melted.
In the examples, the heat resistance of the surface protective material was the measured value of the surface protective material after subjecting to the lamination with the constitutional films and to the aging, as similar to the initial water vapor permeability.

### Constitutional Films

### Weatherproof Film

A-1: A polyvinylidene fluoride (PVDF) film, Kynar 302-PGM-TR (thickness: 30 µm), produced by Arkema, Inc., was used.

### Moisture Proof Films

### Moisture Proof Film B-1

A biaxially stretched polyethylene naphthalate film having a thickness of 12 µm (Q51C12, produced by Teijin DuPont Films Japan Ltd.) was used as a substrate film, and the following coat liquid was coated on the corona-treated surface thereof and dried to form a coat layer having a thickness of 0.1 µm.
Thereafter, SiO was evaporated under heating in vacuum of 1.33 × 10⁻³ Pa (1 × 10⁻⁵ Torr) with a vacuum vapor deposition equipment, thereby providing a moisture proof film B-1 having an SiOₓ (x = 1.5) inorganic thin film layer having a thickness of 50 nm on the coat layer. The moisture proofness of the moisture proof film B-1 thus produced was 0.01 (g/m²·day).

### Coat Liquid

220 g of polyvinyl alcohol, Gohsenol, produced by Nippon Synthetic Chemical Industry Co., Ltd. (saponification degree: 97.0 to 98.8% by mol, polymerization degree: 2, 400), was added to 2, 810 g of ion exchanged water and dissolved therein under heating to form an aqueous solution, to which 645 g of 35% hydrochloric acid was added at 20°C under stirring. Subsequently, 3.6 g of butylaldehyde was added thereto at 10°C under stirring, and after 5 minutes, 143 g of acetaldehyde was added thereto under stirring to deposit resin fine particles. Thereafter, the liquid was maintained at 60°C for 2 hours, then cooled, neutralized with sodium hydrogen carbonate, rinsed with water, and dried, thereby providing polyvinyl acetacetal powder (acetalization degree: 75% by mol).
An isocyanate resin (Sumidur N-3200, produced by Sumika Bayer Urethane Co., Ltd.) as a crosslinking agent was mixed to make an equivalent ratio of isocyanate groups to hydroxyl groups of 1/2.

### Moisture Proof Film B-2

Techbarrier LX, produced by Mitsubishi Plastics, Inc., which was a 12 µm polyethylene terephthalate resin film having silica vapor-deposited thereon, was used. The moisture proofness thereof measured by the aforementioned method was 0.2 (g/m²·day).

### Adhesive and Adhesive Coat Liquids

### Adhesive Coat Liquid 1

HD 1013, produced by Rock Paint Co., Ltd., as a main agent containing a polyurethane polyol component, and H62, produced by Rock Paint Co., Ltd., as a curing agent containing an aliphatic hexamethylene diisocyanate component, were mixed to make a mass ratio of 10/1, and diluted with ethyl acetate to make a solid concentration of 30%, thereby providing an adhesive coat liquid 1.

### Adhesive Coat Liquid 2

A1102, a trade name, produced by Mitsui Chemicals Polyurethanes, Inc., and A3070, produced by Mitsui Chemicals Polyurethanes, Inc., as a curing agent containing an aliphatic hexamethylene diisocyanate component, were mixed to make a mass ratio of 16/1, and diluted with ethyl acetate to make a solid concentration of 30%, thereby providing an adhesive coat liquid 2.

### Back Surface Films

The following back surface films C-1 to C-16 were produced and the both surfaces thereof were subjected to a corona discharge treatment according to an ordinary manner to form a corona treated surface.

### Back Surface Films C-1 and C-2

Titanium oxide (8% by mass) as a whitening agent and titanium oxide ultrafine particles (particle diameter: 0.01 to 0. 06 µm, 3% by mass) as a UV absorber were added to isotactic polypropylene, which were sufficiently kneaded to prepare a polypropylene resin composition. The polypropylene resin composition was extruded with an extruder to produce an unstretched polypropylene (PP) resin film (C-1) having a thickness of 50 µm and an unstretched polypropylene (PP) resin film (C-2) having a thickness of 90 µm.

### Back Surface Film C-3

A polyvinylidene fluoride (PVDF) film, Kynar 302-PGM-TR (thickness: 30 µm), produced by Arkema, Inc., was used as the back surface film C-3.

### Back Surface Film C-4

A polylactic acid (PLA) resin film (Ecoloju S, thickness: 25 µm), produced by Mitsubishi Plastics, Inc., was used as the back surface film C-4.

### Back Surface Films C-5 and C-6

The prescribed additives were added to a low density polyethylene resin, followed by sufficiently kneading, to prepare a low density polyethylene resin composition, and the low density polyethylene resin composition was extruded with an extruder to produce an unstretched low density polyethylene (LDPE) resin film (C-5) having a thickness of 50 µm and an unstretched low density polyethylene (LDPE) resin film (C-6) having a thickness of 100 µm.

### Back Surface Film C-7

Homopolypropylene was used, and MBN05A (2.8% by mass), produced by Japan Polypropylene Corporation, as a master batch of a crystallization nucleating agent, and titanium oxide (8% by mass) as a whitening agent were added to the homopolypropylene, which were sufficiently kneaded to prepare a homopolypropylene resin composition. In the resin composition, the content of the crystallization nucleating agent was 0.15% by mass per 100 parts by mass of the homopolypropylene. The homopolypropylene resin composition and an ethylene-propylene random copolymer were extruded with an extruder to a multilayer structure at a layer thickness ratio of 0.1/0.8/0.1 (the homopolypropylene resin layer for the center layer and the ethylene-propylene random copolymer layers for the outer layers) to produce an unstretched polypropylene resin film having a thickness of 190 µm. The film had an elastic modulus of 1, 250 MPa and a crystallization onset temperature of 131°C. The film was used as the back surface film C-7.

### Back Surface Films C-8, C-9 and C-10

Polyethylene terephthalate (PET) films (Diafoil T-100), produced by Mitsubishi Plastics, Inc., having a thickness of 50 µm (C-8), a thickness of 100 µm (C-9) and a thickness of 188 µm (C-10) were used.

### Back Surface Film C-11

A hydrolysis resistant polyethylene terephthalate (PET) film (P100, thickness: 50 µm), produced by Mitsubishi Plastics, Inc., as a hydrolysis resistant polyester film, was used as C-11.

### Back Surface Film C-12

Apolyamide (PA) 6 film (Santonyl SNR, thickness: 25 µm), produced by Mitsubishi Plastics, Inc., was used as C-12.

### Back Surface Film C-13

An ethylene-tetrafluoroethylene copolymer (ETFE) film (Aflex 50N, 1250NT, thickness: 50 µm), produced by Asahi Glass Co., Ltd., was used as C-13.

### Back Surface Film C-14

A biaxially stretched polyethylene naphthalate (PEN) film (Q51C25, thickness: 25 µm), produced by Teijin DuPont Films Japan Ltd., was used as C-14.

### Back Surface Films C-15 and C-16

Evaflex EV150 (EVA) 38 µm, produced by Du Pont-Mitsui Polychemicals Co., Ltd. , was used as the back surface film C-15. Three sheets of Evaflex EV150 were fused by heating the sheets each on one side to 70°C, thereby producing the back surface film C-16 having a thickness of 114 µm.
The structures, the thicknesses and the melting points of C-1 to C-16 are shown in Table 1.

### Plastic Film

A polyethylene terephthalate (PET) film (Diafoil T-100), produced by Mitsubishi Plastics, Inc., having a thickness of 100 µm was used as the plastic film.

### Encapsulant material

FIRSTEVAF806 (thickness: 500 µm), a trade name, produced by Hangzhou First PV Material Co., Ltd., was used as the EVA encapsulant material.

### Example 1

The adhesive coat liquid 1 was coated on the weatherproof film A-1 and dried to make a solid content of 6 g/m², to which the moisture proof film B-1 was adhered by dry lamination at a tension of approximately 80 N/m, with the inorganic thin film layer thereof being directed to the adhesive surface.
Thereafter, the adhesive coat liquid 1 was coated on the opposite side to the inorganic thin film layer and dried to make a solid content of 6 g/m², to which the corona treated surface of the back surface film C-1 was adhered, followed by aging at 40°C for 5 days, thereby providing a surface protective material D-1 having a thickness of 104 µm. Glass, the encapsulant material and the surface protective material D-1 (with the back surface film being directed to the encapsulant material) were laminated in this order, subjected to vacuum lamination under conditions of 150°C for 15 minutes, and then subjected to the pressure cooker test for measuring the interlayer strength and the moisture proofness. The results are shown in Table 2. The heat resistance was also evaluated. The result is shown in Table 3.

### Example 2

A surface protective material D-2 having a thickness of 144 µm was produced in the same manner as in Example 1 except that the back surface film C-1 in Example 1 was changed to C-2, and after subjecting to vacuum lamination, the surface protective material was subjected to the pressure cooker test for measuring the interlayer strength and the moisture proofness. The results are shown in Table 2. The heat resistance was also evaluated. The result is shown in Table 3.

### Example 3

A surface protective material D-3 having a thickness of 84 µm was produced in the same manner as in Example 1 except that the back surface film C-1 in Example 1 was changed to C-3, and after subjecting to vacuum lamination, the surface protective material was subjected to the pressure cooker test for measuring the interlayer strength and the moisture proofness. The results are shown in Table 2. The heat resistance was also evaluated. The result is shown in Table 3.

### Example 4

A surface protective material D-4 having a thickness of 79 µm was produced in the same manner as in Example 1 except that the back surface film C-1 in Example 1 was changed to C-4, and after subjecting to vacuum lamination, the surface protective material was subjected to the pressure cooker test for measuring the interlayer strength and the moisture proofness. The results are shown in Table 2. The heat resistance was also evaluated. The result is shown in Table 3.

### Example 5

The adhesive coat liquid 1 was coated on one surface of a polyethylene terephthalate (PET) film (Diafoil T-100) having a thickness of 100 µm, produced by Mitsubishi Plastics, Inc., and dried to make a solid content of 6 g/m², and the corona treated surface of the back surface film C-2 was directed to the adhesive surface and adhered thereto by dry lamination.
The adhesive coat liquid 1 was coated on the weatherproof film A-1 and dried to make a solid content of 6 g/m², and the inorganic thin film layer of the moisture proof film B-1 was directed to the adhesive surface and adhered thereto by dry lamination at a tension of approximately 80 N/m.
Thereafter, the adhesive coat liquid 1 was coated on the opposite side to the inorganic thin film layer and dried to make a solid content of 6 g/m², to which the corona treated surface of the back surface film C-2 was adhered, followed by aging at 40°C for 5 days, thereby providing a surface protective material D-5 having a thickness of 250 µm (weatherproof film A-1/moisture proof film B-1/back surface film C-2/PET film) . Glass, the encapsulant material and the surface protective material D-5 (with the PET film being directed to the encapsulant material) were laminated in this order, subjected to vacuum lamination under conditions of 150°C for 15 minutes, and then subjected to the pressure cooker test for measuring the interlayer strength and the moisture proofness. The results are shown in Table 2. The heat resistance was also evaluated. The result is shown in Table 3.

### Example 6

A surface protective material D-6 having a thickness of 104 µm was produced in the same manner as in Example 1 except that the back surface film C-1 in Example 1 was changed to C-5, and after subjecting to vacuum lamination, the surface protective material was subjected to the pressure cooker test for measuring the interlayer strength and the moisture proofness. The results are shown in Table 2. The heat resistance was also evaluated. The result is shown in Table 3.

### Example 7

A surface protective material D-7 having a thickness of 154 µm was produced in the same manner as in Example 1 except that the back surface film C-1 in Example 1 was changed to C-6, and after subjecting to vacuum lamination, the surface protective material was subjected to the pressure cooker test for measuring the interlayer strength and the moisture proofness. The results are shown in Table 2. The heat resistance was also evaluated. The result is shown in Table 3.

### Example 8

The adhesive coat liquid 2 was coated on the weatherproof film A-1 and dried to make a solid content of 6 g/m², to which the moisture proof film B-1 was adhered by dry lamination at a tension of approximately 80 N/m, with the inorganic thin film layer thereof being directed to the adhesive surface.
Thereafter, the adhesive coat liquid 2 was coated on the opposite side to the inorganic thin film layer and dried to make a solid content of 6 g/m², to which the corona treated surface of the back surface film C-7 was adhered, followed by aging at 40°C for 5 days, thereby providing a surface protective material D-8 having a thickness of 244 µm. Glass, the encapsulant material and the surface protective material D-8 (with the back surface film being directed to the encapsulant material) were laminated in this order, subjected to vacuum lamination under conditions of 150°C for 15 minutes, and then subjected to the pressure cooker test for measuring the interlayer strength and the moisture proofness. The results are shown in Table 2. The heat resistance was also evaluated. The result is shown in Table 3.

### Comparative Example 1

A surface protective material D-9 having a thickness of 104 µm was produced in the same manner as in Example 1 except that the back surface film C-1 in Example 1 was changed to C-8, and after subjecting to vacuum lamination, the surface protective material was subjected to the pressure cooker test for measuring the interlayer strength and the moisture proofness. The results are shown in Table 2. The heat resistance was also evaluated. The result is shown in Table 3.

### Comparative Example 2

A surface protective material D-10 having a thickness of 154 µm was produced in the same manner as in Example 1 except that the back surface film C-1 in Example 1 was changed to C-9, and after subjecting to vacuum lamination, the surface protective material was subjected to the pressure cooker test for measuring the interlayer strength and the moisture proofness. The results are shown in Table 2. The heat resistance was also evaluated. The result is shown in Table 3.

### Comparative Example 3

A surface protective material D-11 having a thickness of 242 µm was produced in the same manner as in Example 1 except that the back surface film C-1 in Example 1 was changed to C-10, and after subjecting to vacuum lamination, the surface protective material was subjected to the pressure cooker test for measuring the interlayer strength and the moisture proofness. The results are shown in Table 2. The heat resistance was also evaluated. The result is shown in Table 3.

### Comparative Example 4

A surface protective material D-12 having a thickness of 104 µm was produced in the same manner as in Example 1 except that the back surface film C-1 in Example 1 was changed to C-11, and after subjecting to vacuum lamination, the surface protective material was subjected to the pressure cooker test for measuring the interlayer strength and the moisture proofness. The results are shown in Table 2.

### Comparative Example 5

A surface protective material D-13 having a thickness of 79 µm was produced in the same manner as in Example 1 except that the back surface film C-1 in Example 1 was changed to C-12, and after subjecting to vacuum lamination, the surface protective material was subjected to the pressure cooker test for measuring the interlayer strength and the moisture proofness. The results are shown in Table 2.

### Comparative Example 6

A surface protective material D-14 having a thickness of 104 µm was produced in the same manner as in Example 1 except that the back surface film C-1 in Example 1 was changed to C-13, and after subjecting to vacuum lamination, the surface protective material was subjected to the pressure cooker test for measuring the interlayer strength and the moisture proofness. The results are shown in Table 2.

### Comparative Example 7

A surface protective material D-15 having a thickness of 79 µm was produced in the same manner as in Example 1 except that the back surface film C-1 in Example 1 was changed to C-14, and after subjecting to vacuum lamination, the surface protective material was subjected to the pressure cooker test for measuring the interlayer strength and the moisture proofness. The results are shown in Table 2.

### Comparative Example 8

A surface protective material D-16 having a thickness of 92 µm was produced in the same manner as in Example 1 except that the back surface film C-1 in Example 1 was changed to C-15, and after subjecting to vacuum lamination, the surface protective material was subjected to the pressure cooker test for measuring the interlayer strength and the moisture proofness. The results are shown in Table 2. The heat resistance was also evaluated. The result is shown in Table 3.

### Comparative Example 9

A surface protective material D-17 having a thickness of 168 µm was produced in the same manner as in Example 1 except that the back surface film C-1 in Example 1 was changed to C-16, and after subjecting to vacuum lamination, the surface protective material was subjected to the pressure cooker test for measuring the interlayer strength and the moisture proofness. The results are shown in Table 2. The heat resistance was also evaluated. The result is shown in Table 3.

### Reference Example 1

A surface protective material D-18 having a thickness of 104 µm was produced in the same manner as in Example 1 except that the moisture proof film B-1 in Example 1 was changed to B-2, and after subjecting to vacuum lamination, the surface protective material was subjected to the pressure cooker test for measuring the interlayer strength and the moisture proofness. The results are shown in Table 2.

### Reference Example 2

A surface protective material D-19 having a thickness of 154 µm was produced in the same manner as in Comparative Example 2 except that the moisture proof film B-1 in Comparative Example 2 was changed to B-2, and after subjecting to vacuum lamination, the surface protective material was subjected to the pressure cooker test for measuring the interlayer strength and the moisture proofness. The results are shown in Table 2.

[Table 1]

**Table 1**

| Back surface film No. | Structure of back surface film | Thickness of back surface film (µm) | Melting point of back surface film (°C) |
|---|---|---|---|
| C-1 | PP | 50 | 163 |
| C-2 | PP | 90 | 164 |
| C-3 | PVDF | 30 | 166 |
| C-4 | PLA | 25 | 170 |
| C-5 | LDPE | 50 | 108 |
| C-6 | LDPE | 100 | 108 |
| C-7 | RPP/HPP/RPP | 190 | 131 |
| C-8 | PET | 50 | 253 |
| C-9 | PET | 100 | 253 |
| C-10 | PET | 188 | 253 |
| C-11 | PET P100 | 50 | 252 |
| C-12 | PA | 25 | 220 |
| C-13 | ETFE | 50 | 270 |
| C-14 | PEN | 25 | 263 |
| C-15 | EVA | 38 | 66 |
| C-16 | EVA | 114 | 66 |

| | | | |
|---|---|---|---|
| *HPP: homopolypropylene *RPP: random polypropylene | | | |

[Table 2]

**Table 2**

| | Surface protective material | Moisture proof film | Back surface film | Plastic film | Moisture proofness | | | |
|---|---|---|---|---|---|---|---|---|
| | | | | | Initial (g/m²·day) | After pressure cooker test (g/m²·day) | Deterioration rate | Interlayer strength (N/15 mm) |
| Example 1 | D-1 | B-1 | C-1 | - | 0.01 | 0.10 | 9 | 9.6 |
| Example 2 | D-2 | B-1 | C-2 | - | 0.01 | 0.14 | 13 | 9.5 |
| Example 3 | D-3 | B-1 | C-3 | - | 0.01 | 0.19 | 18 | 9.5 |
| Example 4 | D-4 | B-1 | C-4 | - | 0.01 | 0.12 | 11 | 9.5 |
| Example 5 | D-5 | B-1 | C-2 | PET | 0.01 | 0.10 | 9 | 9.3 |
| Example 6 | D-6 | B-1 | C-5 | - | 0.01 | 0.10 | 9 | 9.6 |
| Example 7 | D-7 | B-1 | C-6 | - | 0.01 | 0.10 | 9 | 9.5 |
| Example 8 | D-8 | B-1 | C-7 | - | 0.01 | 0.16 | 15 | 9.5 |
| Comparative Example 1 | D-9 | B-1 | C-8 | - | 0.01 | 0.55 | 54 | 9.0 |
| Comparative Example 2 | D-10 | B-1 | C-9 | - | 0.01 | 0.62 | 61 | 9.0 |
| Comparative Example 3 | D-11 | B-1 | C-10 | - | 0.01 | 0.82 | 81 | 9.0 |
| Comparative Example 4 | D-12 | B-1 | C-11 | - | 0.01 | 0.36 | 35 | 9.0 |
| Comparative Example 5 | D-13 | B-1 | C-12 | - | 0.01 | 0.45 | 44 | 9.4 |
| Comparative Example 6 | D-14 | B-1 | C-13 | - | 0.01 | 0.44 | 43 | 8.8 |
| Comparative Example 7 | D-15 | B-1 | C-14 | - | 0.01 | 0.65 | 64 | 8.9 |
| Comparative Example 8 | D-16 | B-1 | C-15 | - | 0.01 | 0.12 | 11 | 9.0 |
| Comparative Example 9 | D-17 | B-1 | C-16 | - | 0.01 | 0.11 | 10 | 9.0 |
| Reference Example 1 | D-18 | B-2 | C-1 | - | 0.2 | 0.50 | 1.5 | 9.5 |
| Reference Example 2 | D-19 | B-2 | C-9 | - | 0.2 | 0.55 | 1.75 | 9.3 |

[Table 3]

**Table 3**

| | Surface protective material | Moisture proof film | Back surface film | Plastic film | Heat resistance |
|---|---|---|---|---|---|
| Example 1 | D-1 | B-1 | C-1 | - | A |
| Example 2 | D-2 | B-1 | C-2 | - | A |
| Example 3 | D-3 | B-1 | C-3 | - | A |
| Example 4 | D-4 | B-1 | C-4 | - | A |
| Example 5 | D-5 | B-1 | C-2 | PET | A |
| Example 6 | D-6 | B-1 | C-5 | - | A |
| Example 7 | D-7 | B-1 | C-6 | - | A |
| Example 8 | D-8 | B-1 | C-7 | - | A |
| Comparative Example 1 | D-9 | B-1 | C-8 | - | A |
| Comparative Example 2 | D-10 | B-1 | C-9 | - | A |
| Comparative Example 3 | D-11 | B-1 | C-10 | - | A |
| Comparative Example 8 | D-16 | B-1 | C-15 | - | B |
| Comparative Example 9 | D-17 | B-1 | C-16 | - | B |

As described above, it was apparent from the evaluation by the pressure cooker test that the surface protective materials of Examples 1 to 8, which are each a highly moisture proof surface protective material for a solar cell that contains a highly moisture proof film containing a substrate having on one surface thereof an inorganic thin film layer and having a water vapor permeability of less than 0.1 g/m²·day, and comprises, on the opposite side of the inorganic thin film layer included in the moisture proof film, a back surface film that has a melting point in the particular range, maintained the moisture proof capability for a prolonged period of time even after subjecting to a heat treatment in a vacuum lamination process. It was also found that the surface protective materials of Examples 1 to 8 had a sufficient interlayer strength for a prolonged period of time even after subjecting to the heat treatment. In particular, Example 5 having the plastic film in addition to the back surface film further maintained the moisture proof capability even after the heat treatment.
On the other hand, it was apparent that Comparative Examples 1 to 7, which each had a film having a melting point outside the particular range, on the back surface side of the moisture proof film, suffered notable deterioration of the long-term moisture proof capability after the heat treatment. Reference Examples 1 and 2 each having a low initial moisture proof capability exhibited a small deterioration rate of the moisture proof capability, and showed that the deterioration rate of the moisture proof capability was increased with a higher initial moisture proof capability.
Accordingly, it was thus apparent that the highly moisture proof surface protective material for a solar cell of the present invention had a notable effect of maintaining the moisture proofness particularly in such a highly moisture proof film that was liable to suffer deterioration of the moisture proof capability. Accordingly, the application thereof to a solar cell module particularly prevents invasion of moisture to the solar cell device and deterioration of the surface protective material itself, and thus the durability of the solar cell module may be notably enhanced.

## Claims

1. A surface protective material for a solar cell, comprising:
a moisture proof film that comprises a substrate having on one surface thereof an inorganic thin film layer and has a water vapor permeability of less than 0.1 g/m²·day;
a weatherproof film on a side of the inorganic thin film layer of the moisture proof film; and
a back surface film that has a melting point of 80°C or more and 180°C or less on the opposite side of the inorganic thin film layer of the moisture proof film.

2. The surface protective material for a solar cell according to claim 1, wherein the moisture proof film has a water vapor permeability of 0.05 g/m²·day or less.

3. The surface protective material for a solar cell according to claim 1, wherein the moisture proof film has a water vapor permeability of 0.01 g/m²·day or less.

4. The surface protective material for a solar cell according to any one of claims 1 to 3, wherein the back surface film has a melting point of 130°C or more and 180°C or less.

5. The surface protective material for a solar cell according to any one of claims 1 to 4, wherein the back surface film has a thickness of 25 µm or more and 300 µm or less.

6. The surface protective material for a solar cell according to any one of claims 1 to 5, wherein the back surface film contains, as a major component, at least one kind of a resin selected from polyethylene, polypropylene, polylactic acid, polyvinyl fluoride and polyvinylidene fluoride.

7. The surface protective material for a solar cell according to any one of claims 1 to 5, wherein the back surface film is a polypropylene resin film that contains polypropylene as a major component and has an elastic modulus at 23°C of 1, 000 MPa or more and a crystallization onset temperature of 120°C or more.

8. The surface protective material for a solar cell according to any one of claims 1 to 5 and 7, wherein the back surface film is a polypropylene resin film that contains polypropylene as a major component and contains a crystallization nucleating agent in an amount of 0.05 part by mass or more and 5.0 parts by mass or less per 100 parts by mass of the polypropylene.

9. The surface protective material for a solar cell according to any one of claims 6 to 8, wherein the polypropylene is mainly homopolypropylene.

10. The surface protective material for a solar cell according to any one of claims 7 to 9, wherein the polypropylene resin film comprises multilayer.

11. The surface protective material for a solar cell according to any one of claims 1 to 10, wherein the substrate is a polyester resin film.

12. The surface protective material for a solar cell according to any one of claims 1 to 11, wherein the surface protective material has an adhesive layer between the moisture proof film and the back surface film.

13. The surface protective material for a solar cell according to any one of claims 1 to 12, wherein the surface protective material has, on the opposite side of the inorganic thin film layer included in the moisture proof film, the back surface film and a plastic film in this order.

14. The surface protective material for a solar cell according to any one of claims 1 to 13, wherein the surface protective material further comprises an encapsulant material laminated thereon.

15. A solar cell module that is produced with the surface protective material for a solar cell according to any one of claims 1 to 14.
